# EUROPEAN PATENT SPECIFICATION

(11) **EP 0 569 166 B1**
(45) Date of publication and mention of the grant of the patent: **13.01.1999**
(21) Application number: 93303157.7
(22) Date of filing: 22.04.1993
(51) Int. Cl.: B23K 35/30, B23K 103/08

(54) **Method of soldering**
Verfahren zum Löten
Procédé de soudage

(30) Priority: 01.05.1992 US 877335
(43) Date of publication of application: 10.11.1993
(73) Proprietor: AT&T Corp., New York, NY 10013-2412 (US)
(72) Inventor: Dautartas, Mindaugas Fernand, Alburtis, Pennslvania 18011 (US)
(74) Representative: Johnston, Kenneth Graham

(56) References cited:
- EP-A- 0 114 952
- DE-B- 1 167 162
- FR-A- 1 320 523
- US-A- 3 660 632
- US-A- 4 214 904
- US-A- 4 875 617

## Description

### Background of the Invention

### Technical Field

The present invention relates to methods of soldering.

### Description of the Prior Art

Soldering is a well-known technique for securing metal piece parts in a permanent fashion. Solder material must have the capacity to from metallurgical bonds with the two base metals that are to be joined. The bonding process results in the formation of an alloy in the surface of the base metal characterized by atoms of the soldering composition interspersed between atoms of the base metal.

When the solder is heated to a molten state, it exists as a round droplet as a result of the attraction between the molecules forming the alloy. This attraction is commonly referred to as surface tension. For many technologically advanced applications, such as semiconductor and lightwave technologies, a solder composition of choice is a eutectic gold-tin material which is approximately 80% by weight gold and 20% by weight tin. The eutectic god-tin is often used in soldering components to gold (or gold-plated) bond pad sites.

In a conventional solder process, discrete portions, or preforms of the solder material are disposed or otherwise deposited (e.g., vapor deposition or silk screen paste )on a surface of one of the pieces to be mated (for example, to the bond pad site). The two pieces are joined and heated to a temperature where the solder liquifies (i.e., approximately 315°C in a nitrogen ambient) and reflows over the mating surfaces to provide attachment upon cooling.

There are many known disadvantages to this procedure. First, the reproducibility of the reflow is questionable and sensitive to process variations, particularly since commonly available eutectic Au/Sn solder may only be guaranteed ±1% around the eutectic 80/20 composition. Additionally, the solid state diffusion of tin into an underlying gold bond pad will shift the preform composition to the gold-rich side of the eutectic and could result in poor reflow by raising the melting temperature of the resulting alloy.

In spite of the above drawbacks, however, Au/Sn remains the solder composition of choice since it is compatible with the materials (in particular, gold) used to plate most device surfaces.

Thus, a need remains in the art for some means of overcoming the various drawbacks associated with the eutectic Au/Sn solder.

German Patent 1,167,162 describes bonding a silicon rectifier with two electrodes so that the bottom electrode is bonded to a housing and the top electrode is bonded to a cable. The solder used is 75% gold and 25% tin. The present invention provides

a method of soldering, as sea out in claim 1, with preferred embodiments in claims 2-4.

The need remaining in the prior art is addressed by the present invention which relates to a gold-tin solder and, more particularly, to a gold-tin solder suitable for self-aligning applications.

In accordance with the teachings of the present invention, a tin-rich Au/Sn solder (Au₈₀₋ₓSn₂₀₊ₓ, 0<x≦6) is utilized, preferably in the range of 78/22 to 74/26 (weight % composition). Therefore, if solid state (or liquid state) diffusion of tin into a contacting gold plating layer occurs, the melt temperature will actually drop as the tin is depleted in the solder composition, until the eutectic composition is reached. The use of the tin-rich solder thus insures that the alloy will remain molten during solder reflow.

Further, the soldering process of the present invention may be optimized by heating the solder preform within a reducing ambient such that the further growth of any tin oxide on the surface of the preform (skin oxide) is significantly reduced.

An advantage of the solder composition of the present invention is that self-alignment of piece parts may be achieved. In particular, the utilization of a tin-rich solder allows for the solder to remain liquid and completely cover (i.e., "wet") both bonding surfaces. Therefore, by controlling the size and location of the bonding surfaces, the liquification of the tin-rich solder will result, through surface tension effects, in registration (i.e., centering) of the device with respect to the underlying bond pad.

Other advantages of the present invention will become apparent during the course of the following discussion and by reference to the accompanying drawings.

### Brief Description of the Drawing

Referring now to the drawings, where like numerals represent like parts in several views:
FIGs. 1-3 illustrate an exemplary sequence of steps utilized to provide self-aligned solder attachment in accordance with the teachings of the present invention;
FIG. 4 illustrates in particular the self-aligning ability of the system of the present invention;
FIG. 5 contains a Au/Sn phase diagram useful in understanding the process of the present invention;
FIG. 6 contains a photograph of bond pad coverage when utilizing a conventional prior art eutectic Au/Sn solder; and
FIG. 7 contains a photograph of improved bond pad coverage when utilizing an exemplary tin-rich Au/Sn solder of the present invention.

### Detailed Description

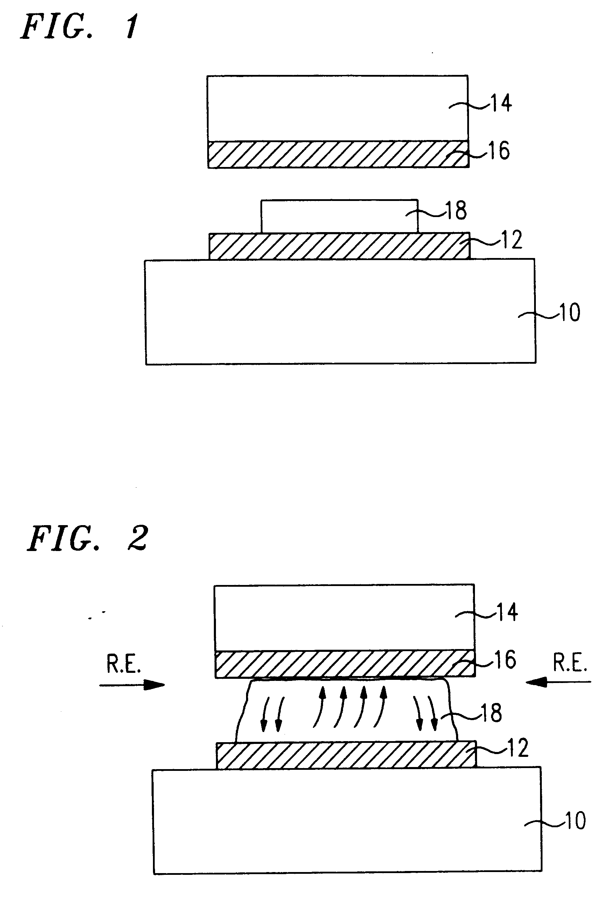

An exemplary process for providing self-aligned solder attachment of a pair of components is illustrated in FIGs. 1-3. The inventive bonding process will be particularly described in association with the self-aligned attachment of an LED to a bond pad. However, it is to be understood that the tin-rich solder of the present invention is ubiquitous in nature and can be utilized within virtually any desired soldering process. Referring back to FIG. 1, a device submount 10, which may be formed of silicon, is illustrated as including a bond pad 12. Conventionally, bond pad 12 is formed of a highly conductive material and, in particular, may comprise a tri-layer structure of titanium, platinum and gold. Gold, in general, is often used for bond pads due to its inert nature and relatively high conductivity. A device 14, such as an LED, is illustrated in FIG. 1 as positioned above bond pad 12. Device 14 also includes a conductive layer 16 (which may also comprise a tri-level, or gold plated layer) to facilitate bonding. In order to provide alignment of device 14 to submount 10, conductive layer 16 should be substantially similar in dimension to bond pad 12.

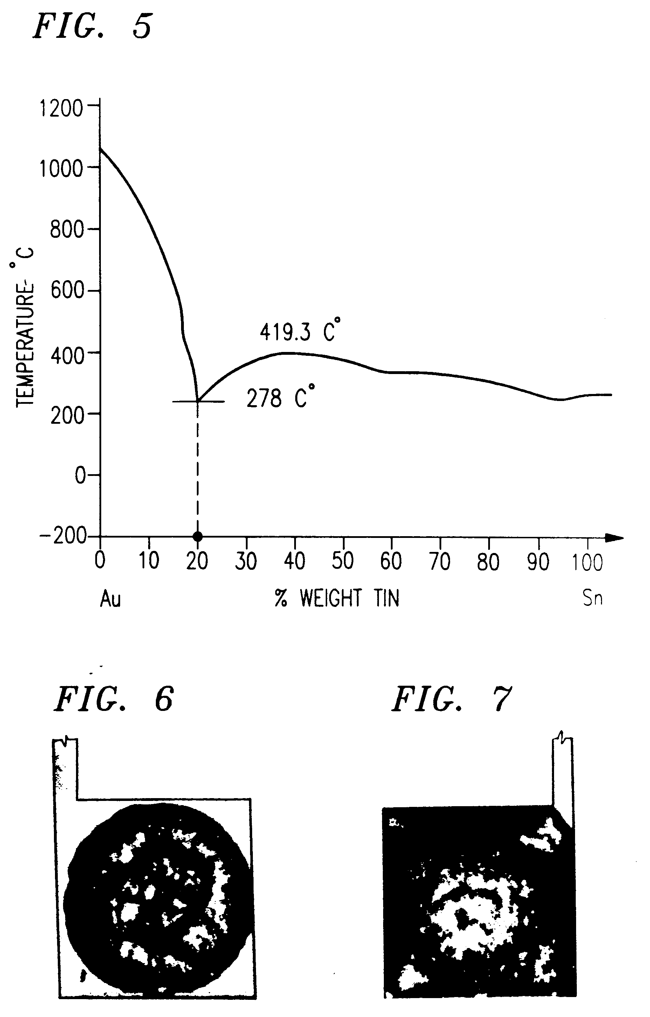

Bonding is achieved, in accordance with the present invention, by utilizing a tin-rich (with respect to the eutectic 80/20) Au/Sn solder preform 18 which is disposed over and brought into contact with bond pad 12. Initially, solder preform 18 may comprise a solid compound, and exhibit a weight percent composition within the range of, for example, 74/26 to 78/22. To initiate bonding, as shown in FIG. 2, device 14 is brought into contact with solder preform 18 and the combination is heated to a temperature (for example, 400°C) at which the tin-rich solder will liquify. As the ambient temperature increases, the rate of solid state diffusion of the tin out of solder 18 and into gold layers 12 and 16 will increase, as indicated by the arrows in FIG. 2. The solid state diffusion is also known to occur with the conventional eutectic solder. In particular, problems arise when utilizing the prior art eutectic in that as the tin diffuses out, the solder becomes gold-rich, and the temperature required for liquifying the solder raises. FIG. 5 contains a Au/Sn phase diagram illustrating the effect of the composition on the phase state of the material. Thus, when soldering at the temperature associated with a "eutectic" solder (e.g., 278°C), a portion of the solder will remain in the solid state and will not completely coat (i.e., "wet") the underlying bond pad.

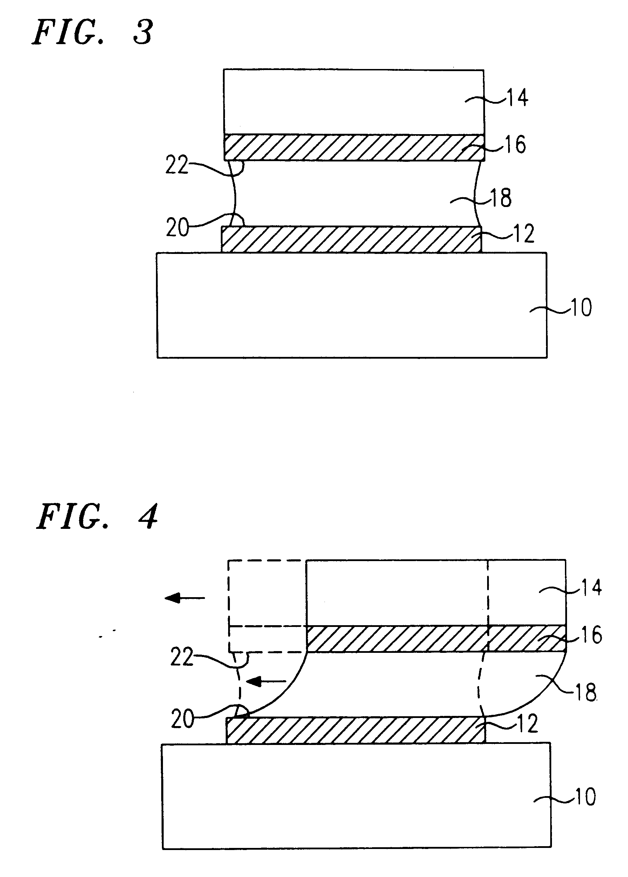

In contrast, when utilizing the tin-rich solder of the present invention, the solid state diffusion of tin from solder preform 18 into bond pad 12 and contact layer 16 results in moving the composition closer to the eutectic, as indicated by the arrow in FIG. 5. That is, as the tin is depleted, the temperature required for liquifying the solder actually drops (following along the line from 419.3°C toward the limit of 278°C), and essentially all of the solder will remain in the liquid state. FIG. 3 illustrates the relative location of device 14 with respect to the liquified solder preform 18. As shown, when completely liquified, solder 18 will completely cover the top surfaces 20,22 of bond pad 12 and conductive layer 16, respectfully. The surface tension created at the outer bound of solder 18 will cause device 14 to center itself, thus resulting in device 14 to be self-aligned with respect to the underlying bond pad 12.

It is known that the soldering operation such as that discussed above will cause a tin oxide layer to form (or an existing layer to increase) at the outer surface of solder 18. The presence of this oxide may necessarily affect the solder reflow. Thus, in the preferred technique of the present invention, the heating step is performed in a reducing ambient which inhibits the formation of this oxide. For example, formic acid may be used to prevent tin oxide formation. Other reducing environments (indicated as "R.E." in FIG. 2) include, but are not limited to, forming gas (20%H₂/80%N₂), carbon monoxide, or any suitable liquid flux.

As mentioned above, an advantage of utilizing the tin-rich solder of the present invention is the ability to provide automatic alignment of a device to an underlying bond pad. Referring to FIG. 3 in particular, the tin-rich solder allows for a device 14 to be aligned with bond pad 12. The coverage of liquified solder 18 with respect to surfaces 20 and 22 of bond areas results in alignment since the solder material will naturally move so as to reduce its overall surface area. Reference is made to FIG. 4 which illustrates a device 14' offset with respect to the underlying bond pad 12. As shown, liquified solder 18 will exhibit an increased surface area with respect to a minimum, as a function of the amount of offset. Thus, the liquified solder will naturally move, in the direction as indicated by the arrows, so as to minimize the surface area. The natural tendency of the solder movement thus results in alignment of the device to the bond pad. Experimentally, it has been found that misalignment on the order of 100µm can be corrected to within a oneµm limit.

FIGs. 6 and 7 contain top views of actual bond pad sites including a reflowed solder preform (original preform being circular in shape). The bond pad of FIG. 6 contains a conventional eutectic 80/20 Au/Sn solder after reflow. As shown, the solder does not completely coat the surface of the bond pad. As discussed above, the out-diffusion of tin into the bond pad results in a gold-rich solder which does not completely liquify and, hence, has poor reflow qualities. In contrast, the bond pad of FIG. 7 contains a tin-rich (76/24) solder of the present invention. As shown, essentially all of the bond pad surface has been coated with the reflowed material.

It is to be understood that the arrangement described above is exemplary only, and the tin-rich Au/Sn solder of the present invention is applicable to any system which requires the soldering of a component to a gold, or gold-plated bond pad.

## Claims

1. A method of self-aligning two components when soldering a first component to a second component, the method comprising the steps of:
a) providing a first component (10) and a second component (14), the first component including a gold bond pad (12) and the second component including a surface layer of gold (16);
b) disposing a Au/Sn solder (18) of the composition in weight percent Au₈₀₋ₓ Sn₂₀₊ₓ, 0<x≦6, between the gold bond pad and surface layer;
c) contacting the first and second components such that the Au/Sn solder is in physical contact with both the gold surface layer and the bond pad; and
d) heating the combination to a temperature sufficient to liquify the Au/Sn solder such that the surface tension of the solder causes the second component to be self-aligned with the gold bond pad.

2. The method of claim 1 wherein performing step b), 2<x≦4.

3. The method of claim 1 wherein in performing step d), the combination is heated to a temperature in excess of 280°C.

4. The method according to claim 1 wherein the first component is a submount and the second component is an LED.

## Patentansprüche

1. Verfahren zum Selbstausrichten zweier Bauteile beim Verlöten eines ersten Bauteils mit einem zweiten Bauteil, wobei das Verfahren die folgenden Schritte beinhaltet:
a) Bereitstellung eines ersten Bauteils (10) und eines zweiten Bauteils (14), wobei das erste Bauteil eine Goldbondinsel (12) und das zweite Bauteil eine Oberflächenschicht aus Gold (16) aufweist;
b) Anbringen eines Au/Sn-Lots (18) der in Gewichtsprozent ausgedrückten Zusammensetzung Au₈₀₋ₓSn₂₀₊ₓ, 0<x≤6 zwischen der Goldbondinsel und der Oberflächenschicht;
c) Inberührungbringen des ersten und des zweiten Bauteils, so daß das Au/Sn-Lot in physischem Kontakt sowohl mit der Goldoberflächenschicht als auch der Bondinsel ist; sowie
d) Erhitzen der Zusammenstellung auf eine zum Verflüssigen des Au/Sn-Lots ausreichende Temperatur, so daß die Oberflächenspannung des Lots ein Selbstausrichten des zweiten Bauteils mit der Goldbondinsel bewirkt.

2. Verfahren nach Anspruch 1, bei dem bei der Durchführung von Schritt b) gilt, daß 2<x≤4.

3. Verfahren nach Anspruch 1, bei dem bei der Durchführung von Schritt d) die Zusammenstellung auf eine Temperatur über 280°C erhitzt wird.

4. Verfahren nach Anspruch 1, bei dem es sich bei dem ersten Bauteil um ein Trägerteil und bei dem zweiten Bauteil um eine LD handelt.

## Revendications

1. Procédé d'auto-alignement de deux composants lors du soudage d'un premier composant sur un second composant, le procédé comprenant les étapes consistant à:
(a) se procurer un premier composant (10) et un second composant (14), le premier composant comportant une plage de connexion en or (12) et le second composant comportant une couche superficielle en or (16);
(b) placer une soudure à l'étain Au/Sn (18) de composition, en pourcentage pondéral, Au₈₀₋ₓSn₂₀₊ₓ, 0 < x ≤ 6, entre la plage de connexion en or et la couche superficielle;
(c) mettre en contact les premier et second composants de façon que la soudure à l'étain Au/Sn soit en contact physique avec à la fois la couche superficielle en or et la plage de connexion; et
(d) chauffer la combinaison à une température suffisante pour liquéfier la soudure à l'étain Au/Sn de telle sorte que la tension superficielle de la soudure à l'étain provoque l'auto-alignement du second composant avec la plage de connexion en or.

2. Procédé selon la revendication 1, dans lequel, dans l'étape (b), 2 < x ≤ 4.

3. Procédé selon la revendication 1, dans lequel, dans l'étape (d), la combinaison est chauffée à une température supérieure à 280°C.

4. Procédé selon la revendication 1, dans lequel le premier composant est un sous-montage et le second composant est une diode luminescente.
